# EUROPEAN PATENT SPECIFICATION

(11) **EP 2 214 110 B1**
(45) Date of publication and mention of the grant of the patent: **01.11.2017**
(21) Application number: 10152300.9
(22) Date of filing: 01.02.2010
(51) Int. Cl.: G06F 17/50

(54) **Heuristic routing for electronic device layout designs**
Heuristisches Routen für Layout-Designs elektronischer Vorrichtungen
Routage heuristique pour designs de mise en page de dispositif électronique

(30) Priority: 30.01.2009 US 363211
(43) Date of publication of application: 04.08.2010
(73) Proprietor: Mentor Graphics Corporation, Wilsonville, OR 97070 (US)
(72) Inventor: Potts, Henry, Ft. Collins, CO 80528 (US); Petunin, Vladimir, Longmont, CO 80503 (US); Zuzin, Yuri, 119501, Moscow (RU); Zuzin, Mikhail, 119501, Moscow (RU)
(74) Representative: Wallin, Nicholas James

(56) References cited:
- US-B1- 6 973 634
- THEUNE D ET AL: "HERO: Hierarchical EMC-constrained routing" PROCEEDINGS OF THE IEEE/ACM INTERNATIONAL CONFERENCE ON COMPUTER AIDED DESIGN (ICCAD). SANTA CLARA, NOV. 8 - 12, 1992; [PROCEEDINGS OF THE IEEE/ACM INTERNATIONAL CONFERENCE ON COMPUTER AIDED DESIGN (ICCAD)], LOS ALAMITOS, IEEE COMP. SOC. PRESS, US LN, vol. CONF. 10, 8 November 1992 (1992-11-08), pages 468-472, XP010094504 ISBN: 978-0-8186-3010-1
- D. EDWARDS ET AL: "University of Manchester PCB Software" 6 October 1994 (1994-10-06), pages 1-66, XP002581767 Retrieved from the Internet: URL:ftp://ftp.cs.man.ac.uk/pub/amulet/pcb/ manual.ps.gz> [retrieved on 2010-05-10]
- FOWLER B: "Designers look beyond autorouting" DIGITAL DESIGN, US, vol. 19, no. 6, 1 June 1989 (1989-06-01), pages 73-75, XP009133386 ISSN: 0147-9245

## Description

### FIELD OF THE INVENTION

The invention relates to the field of electronic design automation. More specifically, various implementations of the invention relate to processes, apparatuses, and systems for routing connections between components within an electronic device, such as a printed circuit board.

### BACKGROUND OF THE INVENTION

Integrated circuit devices are used in a wide variety of modem appliances, such as computers, automobiles, telephones, televisions, manufacturing tools, satellites and even toys. While even a small integrated circuit device can provide a great deal of functionality, almost every integrated circuit device must be electrically connected to an input or output device, to another integrated circuit device, or to some other electronic component in order to be useful. To provide these electrical connections, integrated circuit devices are typically mounted on a printed circuit board (PCB). Most printed circuit boards have a rigid, planar core. The core may be formed, for example, of a sheet of fiberglass material impregnated with epoxy. Conductive lines or "traces" then are formed on one or both surfaces of the core, to electronically connect the components attached to the printed circuit board. The traces may be formed of any desired conductive material, such as copper. With various manufacturing techniques, specific traces may be created by etching a single layer of conductive material in a photolithographic process.

Simple printed circuit boards may have only a single core, with traces on one or both sides of the core. More complex printed circuit boards, however, may have multiple cores, with traces on one or both sides of one or more of the cores. These multilayered printed circuit boards also may include layers of insulating material, to prevent traces on adjacent core surfaces from contacting. In addition, a multilayered printed circuit board will typically include one or more "vias" to electrically connect two or more different layers of the board. A via is created by drilling or otherwise forming a hole through one or more cores. The walls of the via may then be clad with conductive material to form an electrical connection between the different layers. Alternately or additionally, the entire via may be filled with conductive material to form the electrical connection. Some vias may pass through every layer of the board, while other vias may connect only some of the layers in the board. Some vias, referred to as "blind" vias, will connect only internal layers of the board, and are not connected to either the uppermost or lowermost layers. As will be explained in more detail below, vias are employed where, for example, a component requires more traces than can be routed in a corresponding area of a single board layer. The vias allow the component to connect to traces on other layers of the board.

There are a number of steps performed in the design of a printed circuit board. Initially, a designer will create a schematic diagram for the system to be connected through the printed circuit board. This process includes identifying each component that will be included in the system. A system can include "active" components, such as field programmable gate array (FPGA) integrated circuits or application-specific integrated circuits (ASICs). A system also can include "passive" components, such as, resistors, capacitors, and inductors. In addition to identifying each component, the schematic design will represent the electrical connections that must be formed between each component. Next, a designer typically will verify the functionality of the system described in the schematic design. The design may, for example, use software modeling tools to ensure that the system described in the schematic will reliably perform the desired operations. If any errors are detected, then the schematic design may be corrected to address the errors, and the functional verification process repeated.

Once the schematic design is finalized, the designer will typically create a physical design to implement the schematic design. This physical design is sometimes referred to as the design layout or layout design. Herein, design layout and layout design are used interchangeably. The designer will begin by selecting a physical location in the layout design for each component. When a location for a component has been selected, the designer may add a component object, representing that component, to that location in the design layout. The component object may include a variety of information regarding the physical component it represents, such as the configuration of the connection pins used to electrically connect that component to other components. With an integrated circuit device, for example, the substrate with the integrated circuit will be encased in a package for protection from the environment. The connection pins serve to provide an electrical connection, through the packaging, to the electrical contacts of the integrated circuit. After the component objects for the various components are located in the design layout, the designer then will attempt to route traces in the design layout to connect the components as specified in the schematic design.

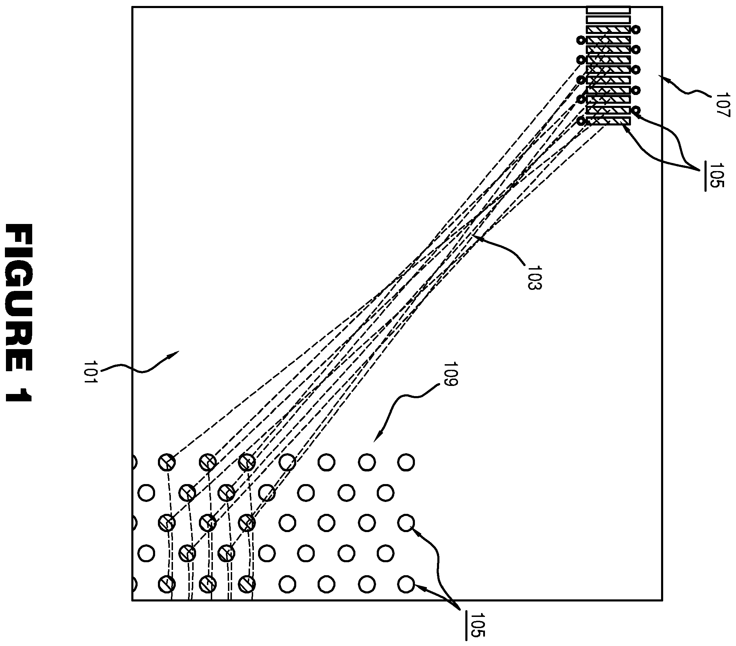

In order to route traces efficiently, a designer may display netlines before routing the traces. A netline is a graphical line rendered in a physical design for a printed circuit board that spans selected pins in a "net." Figure 1 illustrates a layout design 101 containing netlines 103 extending between pins 105 of two separate components 107 and 109. Routing traces is complicated by the fact that many systems have a variety of constraints restricting how a designer can route the traces. For example, a component's minimum current requirement may require that the trace supplying that current have a minimum width. Also, traces may require a minimum separation distance to prevent unacceptable crosstalk. Still further, if a component requires a differential pair connection, then the traces used to implement that differential pair may need to have the same length and maintain a constant distance from each other. Timing constraints may limit the length and/or impedance of a trace. Additionally, traces may not cross, as a connection between the crossing traces would be created.

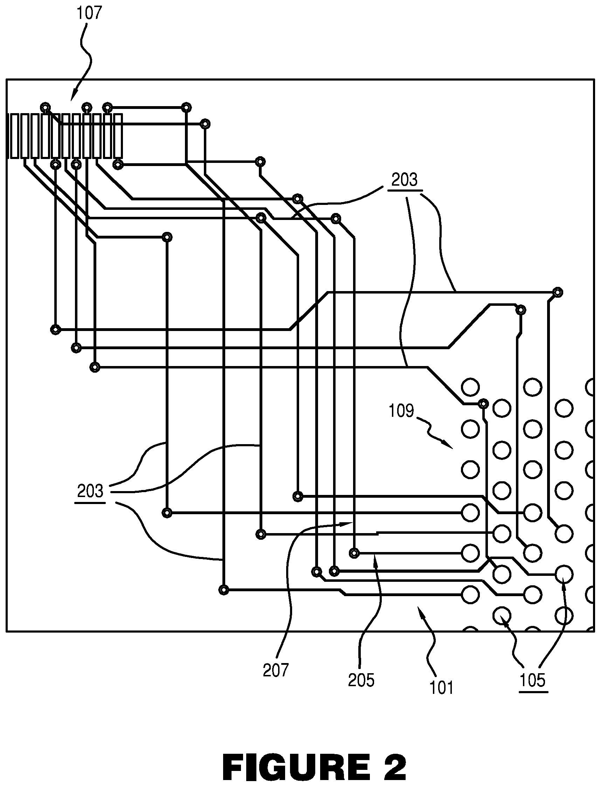

To facilitate routing traces that do not cross over each other, designers will typically assign a bias to each layer of the printed circuit board. The layer bias will specify which direction, for example horizontal or vertical, the traces within that layer should be routed. Figure 2 illustrates the layout design 101 of Figure 1, including the components 107 and 109. As can be seen in Figure 2, traces 203 have been added to the layout design 101. The traces 203 connect the pins 105, as indicated by the netlines 103 from Figure 1. As further illustrated, some of the traces 203 are routed horizontally while others of the traces 203 are routed vertically on a separate layer. More particularly, Figure 2 shows a horizontal trace 205 and a vertical trace 207. As can be seen, the horizontal trace 205 is routed on a different layer of the layout design than the vertical trace 207 is routed. It is to be appreciated that the horizontal or vertical connotation associated with the bias of a particular trace or layer within a layout design depends upon some point of reference, for example the x-axis in Cartesian coordinates. Accordingly, although a horizontal or vertical bias is frequently referenced herein, the particular horizontal or vertical reference is not intended to be limiting.

After creating an initial physical design and routing traces within the layout design, a designer may revise either the physical design or the layout design several times before it is finished. These revisions may include, for example, moving the pathways for traces, altering the width of traces at various points along their lengths, creating partial traces or "hangers," moving the location of one or more of the components, and rotating the orientation of one or more of the components. Each revision, however, may itself require related revisions. For example, if a component is moved or rotated, then every existing trace associated with that component must be discarded and replaced.

Most modem designs contain many components, and as a result, many more netlines 103 and traces 203 than illustrates by Figure 1 and Figure 2. For example, a modem design may contain thousands of components and thousands of netlines, which adds to the complexity and tedium of routing traces. Although routing traces by hand is possible, due to the scale of most modem designs, automated trace routing tools have been developed. For example, the DxDesigner toolset available from Mentor Graphics Corporation of Wilsonville, Oregon may be used to assist a designer with automated trace routing. Automated trace routing tools place traces in the design layout based upon a variety of heuristics, one of which is the layer bias.

The layer bias heuristic is a fundamental heuristic as it prevents routed traces from crossing and leaves routing channels open for other traces. However, the layer bias heuristic is also severely limited. For example, the layer bias depends upon circumstances that occur during planning and routing of the traces. Accordingly, traces placed in harmony with the layer bias heuristic may not be routed in the best location, as the layer bias may changes during routing.

HERO : Hierarchical EMC-constrained routing, by Theune et al, presented at the Proceedings of the IEEE/ACM International Conference on Computer Aided Design, 1992 discloses methods for incorporating complex electromagnetic compatibility constraints into printed circuit board routing. HERO uses hierarchical routing methods in which printed circuit boards are partitioned and designed and assigned to the different layers of a printed circuit board, and incorporate EMCs - design rules which make use of preferred wiring directions.

D Edwards et al "University of Manchester PCB Software" of 6 October 1994, discloses a graphical interactive editor for routing printed circuit board designs, and describes another interactive device placement scheme.

### SUMMARY OF THE INVENTION

Various implementations of the invention provide a method for dynamically determining a layer bias. In various implementations, the layer bias may be employed to determine placement locations for a trace within an electrical device layout design. The trace providing for the electrical connection of components or pins within the layout design. With various implementations of the invention, a layer within the layout design is partitioned into regions, selected regions having a bias. As events or alterations to the layout design occur, the corresponding bias for the selected regions is updated to reflect any changes in bias occurring due to the event or alteration. With other implementations of the invention, processes, machines, or manufactures are provided that dynamically determine a layer bias. The dynamically determined layer bias may be incorporated into a layer bias heuristic employed by for example, an automated trace routing tool.

From one aspect, the present invention provides a computer-implemented method for modifying an electronic device design layout as defined in claim 1.

From another aspect the present invention provides a computer program product for enabling a computer to alter a portion of a layout design as defined in claim 8.

From a further aspect there is also provided a computer system adapted to manipulate design data as defined in claim 14.

Within this aspect, the computer system may be further arranged to perform any and all operations performed in the corresponding method, and particularly as defined in claims 2 to 7.

### BRIEF DESCRIPTION OF THE DRAWINGS

The present invention will be described by way of illustrative embodiments shown in the accompanying drawings in which like references denote similar elements, and in which:
Figure 1 illustrates a printed circuit board layout design including netlines;
Figure 2 illustrates the printed circuit board layout design of Figure 1, with traces routed according to the netlines;
Figure 3 illustrates a computer system, useable for implementing various embodiments of the present invention;
Figure 4 illustrates a computer processing unit of the computer system illustrated in Figure 3;
Figure 5 illustrates a method of dynamically adjusting a layer bias heuristic;
Figure 6 illustrates a layout design, including partitioned layers within the layout design;
Figure 7 illustrates a method of generating a layer bias map;
Figure 8 illustrates a method of determining a local layer bias;
Figure 9 illustrates a layer of a layout design;
Figure 10 illustrates the layer of Figure 9, shown with further detail;
Figure 11 illustrates a method of routing traces according to a layer bias heuristic;
Figure 12 illustrates a method of routing traces according to a layer bias heuristic;
Figure 13 illustrates an apparatus for dynamically generating a layer bias map.

### DETAILED DESCRIPTION OF ILLUSTRATIVE EMBODIMENTS

### Introduction

As detailed above, a layer bias heuristic may be employed by an automated trace routing tools to assist in determining trace placement locations within an electronic device layout design. The term layer bias heuristic is used herein to refer to the rules and policies used to determine how traces should be routed. One metric the layer bias heuristic uses to determine trace placement is the layer bias. Typically, the layer bias heuristic does not change during automated trace routing, although the layer bias does. Accordingly, detailed herein are methods, apparatuses, and systems for dynamically determining a layer bias. The disclosed methods, apparatus, and systems should not be construed as limiting in any way. Instead, the present disclosure is directed toward all novel and nonobvious features and aspects of the various disclosed methods, apparatus, systems, and equivalents thereof, alone and in various combinations and subcombinations with one another. The present disclosure is not limited to any specific aspect or feature, or combination thereof, nor do the disclosed methods, apparatus, and systems require that any one or more specific advantages be present or problems be solved.

Although the operations of some of the disclosed methods, apparatus, and systems are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the figures may not show the various ways in which the disclosed methods, apparatus, and systems can be used in conjunction with other methods, apparatus, and systems. Additionally, the description sometimes uses terms like "generate" and "determine" to describe the disclosed methods. These terms are high-level abstractions of the actual operations that are performed. The actual operations that correspond to these terms may vary depending on the particular implementation and are readily discernible by one of ordinary skill in the art.

Various implementations of the invention apply to dynamically determining a layer bias. With further implementations of the invention, the dynamically determined layer bias is implemented in a layer bias heuristic useful for the automated routing of traces within a layout design. For example, the layout design of printed circuit boards or application-specific integrated circuits (ASICs), including mixed-signal application-specific integrated circuits, systems-on-a-chip (SoCs), and programmable logic devices (PLDs), such as field programmable gate arrays (FPGAs). Furthermore, various implementations of the invention may be employed to adjust the layer bias heuristic as an automated trace routing tool routes traces. For example, after a single trace is routed, the layer bias heuristic may be adjusted, or after a group of traces is routed, the layer bias heuristic may be adjusted. Furthermore, various embodiments of the invention may be implemented to manipulate, modify, or otherwise change data, representing a layout design. However, as those of skill in the art will appreciate, the manipulated, modified, or otherwise changed data represents the layout design for a physical device. Accordingly, the layout design may be employed in a manufacturing process to create the physical device according to the manipulated, modified, or otherwise changed layout design.

With various implementations, the intermediate results or the final output produced by any of the disclosed methods, apparatus, and systems can be stored on one or more computer readable medium as part of the described methods and techniques. Additionally, a computer readable medium bearing the intermediate results or the final output may be accessed and used by a single programmable computing device or a plurality of programmable computing devices, which may be connected on a network.

Various implementations of the invention may use circuit design information. For example, printed circuit board layout information, such as a .HYP file, device models such as IBIS models, netlists, GDSII descriptions, or HDL descriptions such as Verilog or VHDL description, or other similar layout or device design description stored on one or more computer readable medium. In certain implementations, the circuits to be simulated are instantiated as SPICE or Eldo models for simulation. For presentation purposes, the present disclosure sometimes refers to circuit components by their physical counterparts, such as drivers, channels, signals, and other such terms. It should be understood, however, that any such reference not only includes the physical components but also representations of such circuit components and signals on the components as may be used in a computer implemented electronic design automation (EDA) tool.

Any of the methods or techniques described herein can be performed using software that comprises computer executable instructions for causing a computer to perform the methods or techniques stored on one or more computer readable medium. Such software can comprise, for example, an electronic design automation tool. With various implementations of the invention, the software may be executed on a single computer. With other implementations, the software may be executed upon a networked computer system. For example, via the Internet, a wide area network, a local area network, a client server network, or other such network. For clarity, only certain selected aspects of the software based implementations are described. Other details that are well known in the art are omitted. For example, it should be understood that the disclosed technology is not limited to any specific computer language, program, or computer and that the disclosed technology can be implemented using any commercially available computer. An illustrative computing environment is described, but it is to be understood that this environment is not limiting and although all possible computing environments are not described, those of skill in the art are still capable of practicing the invention based upon the following disclosure.

As stated, it is to be appreciated that although various references herein are made to a horizontal, vertical, or other directional bias. The particular connotation of bias, such as horizontal, depends upon some point of reference. Accordingly, various implementations of the invention may employ an arbitrary reference point, such as the y-axis. Additionally, those of skill in the art are capable of implementing the invention with various arbitrary points of reference and various arbitrary names for a particular connotation of bias.

### Exemplary Computing Environment

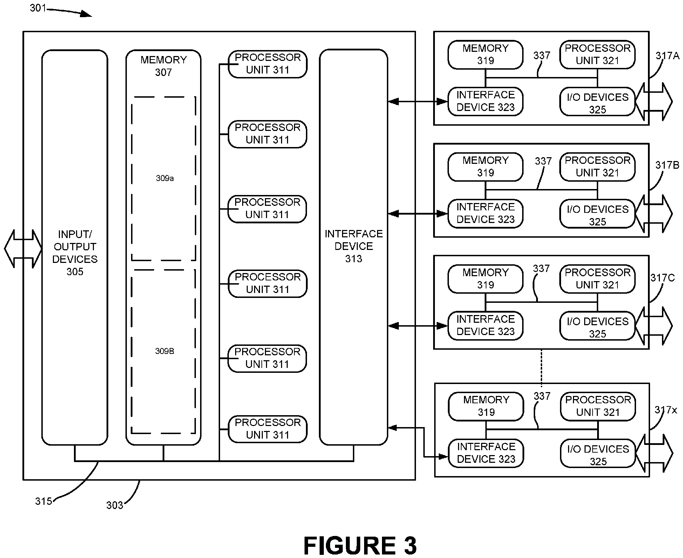

Various embodiments of the invention are implemented using computer executable software instructions executed by one or more programmable computing devices. Because these examples of the invention may be implemented using software instructions, the components and operation of a generic programmable computer system on which various embodiments of the invention may be employed is described. Further, because of the complexity of some electronic design automation processes and the large size of many circuit designs, various electronic design automation tools are configured to operate on a computing system capable of simultaneously running multiple processing threads. The components and operation of a computer network 301 having a host or master computer and one or more remote or slave computers therefore will be described with reference to Figure 3. This operating environment is only one example of a suitable operating environment, however, and is not intended to suggest any limitation as to the scope of use or functionality of the invention.

In Figure 3, the computer network 301 includes a master computer 303. In the illustrated example, the master computer 303 is a multi-processor computer that includes a plurality of input and output devices 305 and a memory 307. The input and output devices 305 may include any device for receiving input data from or providing output data to a user. The input devices may include, for example, a keyboard, microphone, scanner or pointing device for receiving input from a user. The output devices may then include a display monitor, speaker, printer or tactile feedback device. These devices and their connections are well known in the art, and thus will not be discussed at length here.

The memory 307 may similarly be implemented using any combination of computer readable media that can be accessed by the master computer 303. The computer readable media may include, for example, microcircuit memory devices such as random access memory (RAM), read-only memory (ROM), electronically erasable and programmable read-only memory (EEPROM) or flash memory microcircuit devices, CD-ROM disks, digital video disks (DVD), or other optical storage devices. The computer readable media may also include magnetic cassettes, magnetic tapes, magnetic disks or other magnetic storage devices, punched media, holographic storage devices, or any other medium that can be used to store desired information.

As will be discussed in detail below, the master computer 303 runs a software application for performing one or more operations according to various examples of the invention. Accordingly, the memory 307 stores software instructions 309A that, when executed, will implement a software application for performing one or more operations. The memory 307 also stores data 309B to be used with the software application. In the illustrated embodiment, the data 309B contains process data that the software application uses to perform the operations, at least some of which may be parallel.

The master computer 303 also includes a plurality of processor units 311 and an interface device 313. The processor units 311 may be any type of processor device that can be programmed to execute the software instructions 309A, but will conventionally be a microprocessor device. For example, one or more of the processor units 311 may be a commercially generic programmable microprocessor, such as Intel® Pentium® or Xeon™ microprocessors, Advanced Micro Devices Athlon™ microprocessors or Motorola 68K/Coldfire® microprocessors. Alternately or additionally, one or more of the processor units 311 may be a custom manufactured processor, such as a microprocessor designed to optimally perform specific types of mathematical operations. The interface device 313, the processor units 311, the memory 307 and the input/output devices 305 are connected together by a bus 315.

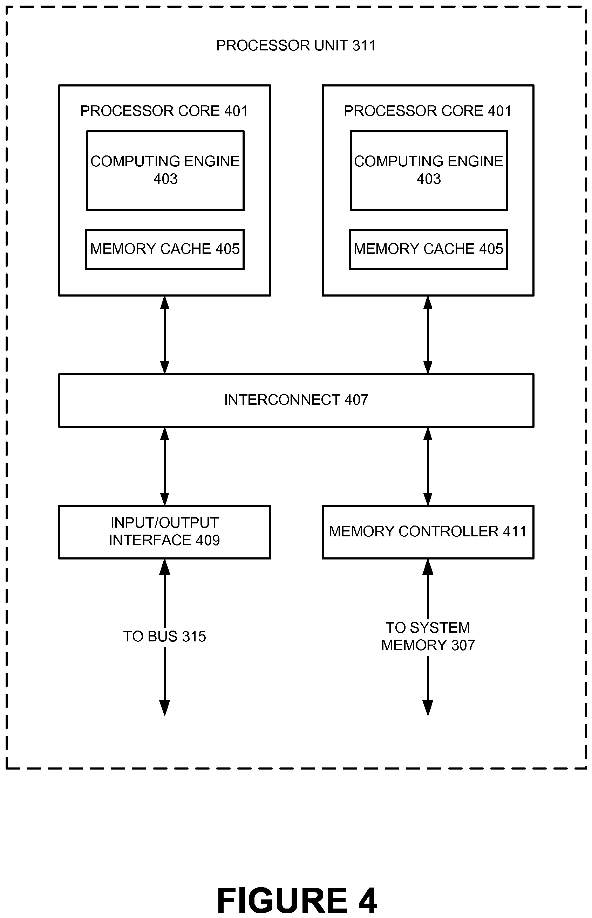

With some implementations of the invention, the master computing device 303 may employ one or more processing units 311 having more than one processor core. Accordingly, Figure 4 illustrates an example of a multi-core processor unit 311 that may be employed with various embodiments of the invention. As seen in this figure, the processor unit 311 includes a plurality of processor cores 401. Each processor core 401 includes a computing engine 403 and a memory cache 405. As known to those of ordinary skill in the art, a computing engine contains logic devices for performing various computing functions, such as fetching software instructions and then performing the actions specified in the fetched instructions. These actions may include, for example, adding, subtracting, multiplying, and comparing numbers, performing logical operations such as AND, OR, NOR and XOR, and retrieving data. Each computing engine 403 may then use its corresponding memory cache 405 to quickly store and retrieve data and/or instructions for execution.

Each processor core 401 is connected to an interconnect 407. The particular construction of the interconnect 407 may vary depending upon the architecture of the processor unit 401. With some processor cores 401, such as the Cell microprocessor created by Sony Corporation, Toshiba Corporation and IBM Corporation, the interconnect 407 may be implemented as an interconnect bus. With other processor cores 401, however, such as the Opteron™ and Athlon™ dual-core processors available from Advanced Micro Devices of Sunnyvale, California, the interconnect 407 may be implemented as a system request interface device. In any case, the processor cores 401 communicate through the interconnect 407 with an input/output interfaces 409 and a memory controller 411. The input/output interface 409 provides a communication interface between the processor unit 411 and the bus 315. Similarly, the memory controller 411 controls the exchange of information between the processor unit 311 and the system memory 307. With some implementations of the invention, the processor units 311 may include additional components, such as a high-level cache memory accessible shared by the processor cores 401.

While Figure 4 shows one illustration of a processor unit 311 that may be employed by some embodiments of the invention, it should be appreciated that this illustration is representative only, and is not intended to be limiting. For example, some embodiments of the invention may employ a master computer 303 with one or more Cell processors. The Cell processor employs multiple input/output interfaces 409 and multiple memory controllers 411. Also, the Cell processor has nine different processor cores 401 of different types. More particularly, it has six or more synergistic processor elements (SPEs) and a power processor element (PPE). Each synergistic processor element has a vector-type computing engine 403 with 128 x 128 bit registers, four single-precision floating point computational units, four integer computational units, and a 256KB local store memory that stores both instructions and data. The power processor element then controls that tasks performed by the synergistic processor elements. Because of its configuration, the Cell processor can perform some mathematical operations, such as the calculation of fast Fourier transforms (FFTs), at substantially higher speeds than many conventional processors.

It also should be appreciated that, with some implementations, a multi-core processor unit 311 can be used in lieu of multiple, separate processor units 311. For example, rather than employing six separate processor units 311, an alternate implementation of the invention may employ a single processor unit 311 having six cores, two multi-core processor units 311 each having three cores, a multi-core processor unit 311 with four cores together with two separate single-core processor units 311, or other desired configuration.

Returning now to Figure 3, the interface device 313 allows the master computer 303 to communicate with the slave computers 317A, 317B, 317C...317x through a communication interface. The communication interface may be any suitable type of interface including, for example, a conventional wired network connection or an optically transmissive wired network connection. The communication interface may also be a wireless connection, such as a wireless optical connection, a radio frequency connection, an infrared connection, or even an acoustic connection. The interface device 313 translates data and control signals from the master computer 303 and each of the slave computers 317 into network messages according to one or more communication protocols, such as the transmission control protocol (TCP), the user datagram protocol (UDP), and the Internet protocol (IP). These and other conventional communication protocols are well known in the art, and thus will not be discussed here in more detail.

Each slave computer 317 may include a memory 319, a processor unit 321, an interface device 323, and, optionally, one more input/output devices 325 connected together by a system bus 327. As with the master computer 303, the optional input/output devices 325 for the slave computers 317 may include any conventional input or output devices, such as keyboards, pointing devices, microphones, display monitors, speakers, and printers. Similarly, the processor units 321 may be any type of conventional or custom-manufactured programmable processor device. For example, one or more of the processor units 321 may be commercially generic programmable microprocessors, such as Intel® Pentium® or Xeon™ microprocessors, Advanced Micro Devices Athlon™ microprocessors or Motorola 68K/Coldfire® microprocessors. Alternately, one or more of the processor units 321 may be custom manufactured processors, such as microprocessors designed to optimally perform specific types of mathematical operations. Still further, one or more of the processor units 321 may have more than one core, as described with reference to Figure 3 above. For example, with some implementations of the invention, one or more of the processor units 321 may be a Cell processor. The memory 319 then may be implemented using any combination of the computer readable media discussed above. Like the interface device 313, the interface devices 323 allow the slave computers 317 to communicate with the master computer 303 over the communication interface.

In the illustrated example, the master computer 303 is a multi-processor unit computer with multiple processor units 311, while each slave computer 317 has a single processor unit 321. It should be noted, however, that alternate implementations of the invention may employ a master computer having single processor unit 311. Further, one or more of the slave computers 317 may have multiple processor units 321, depending upon their intended use, as previously discussed. Also, while only a single interface device 313 or 323 is illustrated for both the master computer 303 and the slave computers 317, it should be noted that, with alternate embodiments of the invention, either the master computer 303, one or more of the slave computers 317, or some combination of both may use two or more different interface devices 313 or 323 for communicating over multiple communication interfaces.

With various examples of the invention, the master computer 303 may be connected to one or more external data storage devices. These external data storage devices may be implemented using any combination of computer readable media that can be accessed by the master computer 303. The computer readable media may include, for example, microcircuit memory devices such as random access memory (RAM), read-only memory (ROM), electronically erasable and programmable read-only memory (EEPROM) or flash memory microcircuit devices, CD-ROM disks, digital video disks (DVD), or other optical storage devices. The computer readable media may also include magnetic cassettes, magnetic tapes, magnetic disks or other magnetic storage devices, punched media, holographic storage devices, or any other medium that can be used to store desired information. According to some implementations of the invention, one or more of the slave computers 317 may alternately or additions be connected to one or more external data storage devices. Typically, these external data storage devices will include data storage devices that also are connected to the master computer 303, but they also may be different from any data storage devices accessible by the master computer 303.

It also should be appreciated that the description of the computer network illustrated in Figure 3 and Figure 4 is provided as an example only and is not intended to suggest any limitation as to the scope of use or functionality of alternate embodiments of the invention.

### Dynamically Determining A Layer Bias

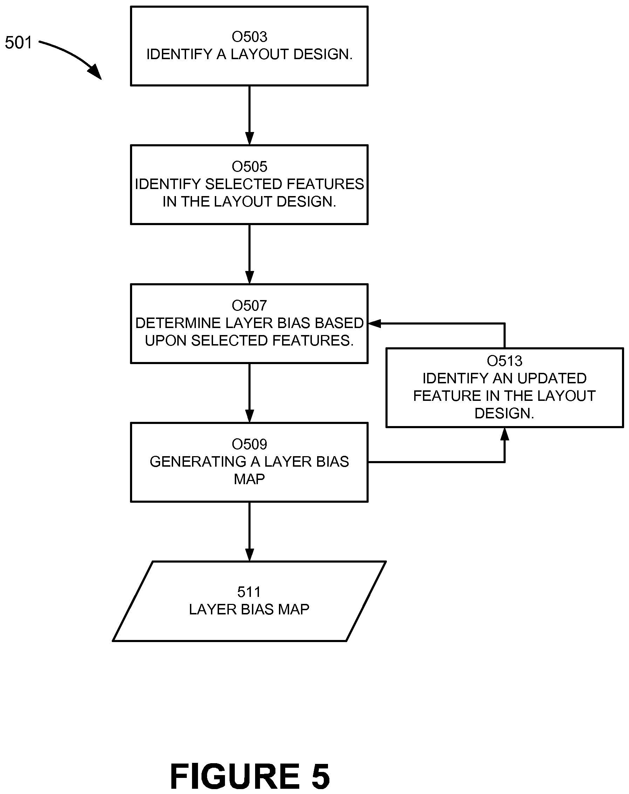

As stated above, various implementations of the invention may be employed to dynamically determine a layer bias. Figure 5 illustrates a method 501 that may be provided according to various implementations of the invention. The method 501 includes an operation 503 for identifying a portion of a layout design (not shown). With various implementations of the invention, the layout design is a layout design for a printed circuit board. With other implementations of the invention, the layout design is a selected portion of a layout design for a printed circuit board. Still, with other implementations of the invention, the layout design is a layout design for an integrated circuit, for example, a system-on-chip integrated circuit.

The method 501 further includes an operation 505 for identifying selected features within the layout design. In various implementations of the invention, the selected features are traces routed within the layout design. With various other implementations, the selected features are netlines. With still other various implementations, the selected features are any features indicative of a layer bias, such as a trace, a netline, a bus path, an edge of the layout design, an outline of conductive material within the layout design, or other feature indicative of layer bias.

Once the selected features are identified, the method includes an operation 507 for determining a layer bias based upon the selected features. In some implementations of the invention, the layer bias is determined for a single layer within the layout design. With various implementations of the invention, the layout design contains a plurality of layers. Accordingly, the layer bias may be determined for each layer within the layout design. With still other implementations of the invention, the layer bias may be determined for a selection of the layers within the layout design. For example, the layer bias for some layers of the layout design 507, such as the power layer and ground plane layer may not be determined.

After the layer bias is determined, the method includes an operation 509 for generating a layer bias map 511. The layer bias map specifies the determined layer bias for selected portions of the identified layout design. In various implementations of the invention, the layer bias map 511 employs a matrix format to specify the layer bias. With alternative implementations, the layer bias map 511 employs a list format to specify the layer bias. With still alternate implementations, the layer bias map 511 employs a vector field format to specify the layer bias. In various further implementations of the invention, the layer bias map 511 is stored to a memory storage location after it is generated by the operations 509.

The method 501 additionally includes an operation 513 for identifying an updated feature within the layout design. With various implementations of the invention, the updated feature is a new trace routed in the layout design 507. In various further implementations of the invention, the new trace is routed manually by a user. In various alternate implementations of the invention, the new trace is routed by an automated trace routing tool. With still other various implementations of the invention, the updated feature is the addition of a feature indicative of layer bias to the layout design. For example, the additional feature may be a netline, a bus path, or another feature known to convey a layer bias. Still, with various other implementations of the invention, the updated feature is the removal of a trace, netline, bus path, or other feature indicative of a layers bias.

Once the operation 513 identifies an updated feature, the operation 507 again determines the layer bias based upon selected features and the layer bias map 511 is again generated by the operation 509. In various implementations of the invention, the layer bias map 511 is completely regenerated. With various alternate implementations, the layer bias map 511 is merely updated to reflect any changed resulting from the updated feature.

### A Layer Bias Map

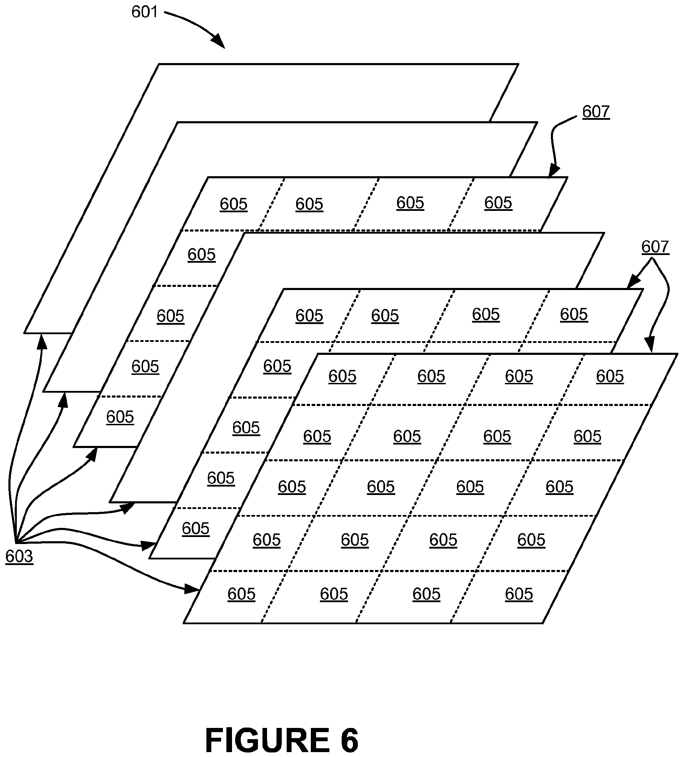

As can be seen, the method 501 may be implemented to dynamically determine a layer bias. For example, as traces are added to a layout design, the layer bias may be periodically determined and updated to reflect any changed resulting from the additional traces. As stated, with various implementations of the invention, layer bias is determined for selected layer within a layout design. In various further implementations of the invention, layer bias is determined for selected regions within one or more selected layers of a layout design. This is illustrated in greater detail by reference to Figure 6.

Figure 6 illustrates a layout design 601. The layout design 601 includes a plurality of layers 603. As can be seen in Figure 6, some of the layers 603 have been partitioned into regions 605, resulting in partitioned layers 607. In various implementations of the present invention, the regions 605 may be a few millimeters square. A layer bias may be determined for selected regions 605 within one or more of the partitioned layers 607. The layer bias for a particular region 605 is often referred to herein as the local layer bias or local bias. In various implementations of the invention, the layer bias map, such as the layer bias map 511, specifies the local bias for selected regions.

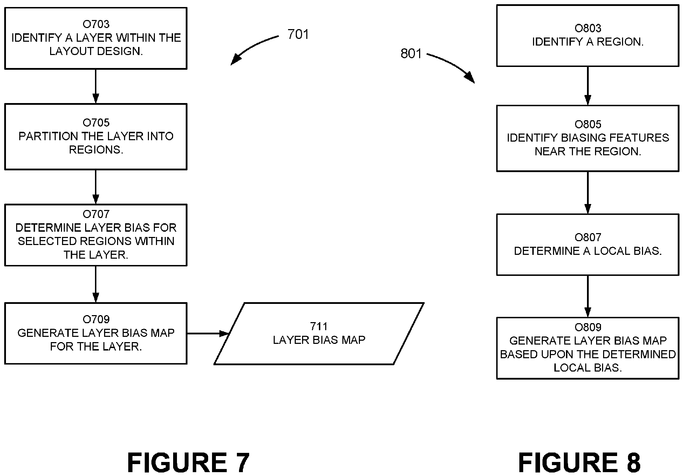

Figure 7 illustrates a method 701, which may be implemented according to various embodiments of the present invention to generate a layer bias map. For example, the operation 509 shown in Figure 5 may be performed according to the method 701. As can be seen in Figure 7, the method 701 includes an operation 703 for identifying a layer (not shown) within a layout design (not shown). The method 701 further includes an operation 705 for partitioning the identified layer into regions. For example, the operation 703 may identify one of the layers 603 illustrated in Figure 6. Accordingly, the operation 705 may partition the identified layer into regions, resulting in a partitioned layer, such as the layers 607.

The method 701 further includes an operation 707 for determining a layer bias for selected regions, such as the regions 605, within the identified layer. The layer bias corresponding to a selection of regions within a layer map may be referred to as the local layer bias. The method 701 additionally includes an operation 709 for generating a layer bias map 711, which specifies the determined layer bias for the selected regions. More particularly, the layer bias map references the local bias corresponding to selected regions within one or more layers of a layout design. As stated, with various implementations of the invention, the method 501 generates a layer bias map according to the method 701. Accordingly, the layer bias map 511 would correspond to the layer bias map 711. As stated above, with various implementations of the invention, a layer bias map, such as the layer bias map 711, may correspond to a single layer within a layout design or multiple layers within a layout design. Although some descriptions herein detail a layer bias map referencing a single layer, those of skill in the art are capable of generating a layer bias map that references multiple layers based upon the present disclosure.

In various implementations of the invention, the layer bias map 711 specifies the layer bias in terms of horizontal and vertical bias. Returning to Figure 2, as can be seen the trace 207 is vertically routed. Accordingly, a layer bias map, such as the layer bias map 711, containing a reference to the layer upon which the trace 207 is routed may specify the layer as a vertically biased layer. Furthermore, as can be seen, Figure 2 contains the trace 205, which is horizontally routed. Accordingly, a layer bias map referencing the layer upon which the trace 205 is routed may specify the layer as a horizontally biased layer.

Figure 8 illustrates a method 801 that may be implemented according to various embodiments of the invention to determine a layer bias or a local layer bias. The method 801 includes an operation 803 for identifying a region (not shown) from within a layout design (not shown). For example, the operation 803 may identify a selected one of the regions 605 of the layout design 601 shown in Figure 6. The method 801 further includes an operation 805 for identifying biasing features near the identified region. As stated above, a biasing feature may be any feature, such as a trace or netline, which is indicative of layer bias. In various implementations of the invention, a biasing feature will be identified as near the identified region if the biasing feature is located within the boundary of the identified region. Alternatively or additionally, with other implementations of the invention a biasing feature will be identified as near the identified region if the biasing feature touches a boundary of the identified region. Alternatively or additionally still, with other implementations of the invention a biasing feature will be identified as near the identified region if the biasing feature is located a selected distance from the identified region. In various implementations of the present invention, biasing features will be identified as near a particular region if the biasing features are within a distance of a few millimeters from the region.

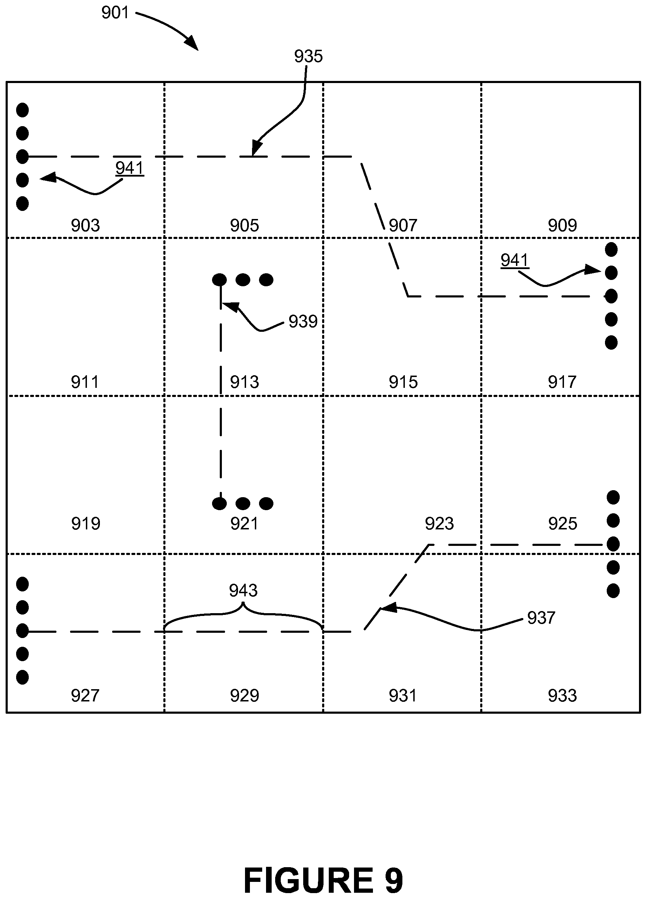

Figure 9 illustrates a partitioned layer 901, including regions 903 - 933. The partitioned layer 901 further includes traces, or biasing features, 935 - 939 and pins 941. As can be seen in Figure 9, the biasing feature 935 is routed horizontally within the regions 903, 905, 907, 915, and 917. Additionally, as illustrated, the biasing feature 935 is routed diagonally within the regions 907 and 915. In various implementations of the invention, a diagonal bias may be specified for a selected layer or for selected regions, such as the region 907 and the region 915. With further implementations of the invention, the region 907 and the region 915 may be referenced as having a negative diagonal bias or a positive diagonal bias. More particularly, a positive or negative connotation may be assigned to a particular diagonally routed biasing feature. It is to be appreciated that often angles are given a sign of positive if measured anticlockwise and negative if measured clockwise from a given reference line, for example the x-axis in the Cartesian plane. In various implementations of the invention a biasing feature routed diagonally, wherein the angle of the biasing feature, relative to the horizontal axis and reading from left to right, is greater than 180 degrees will be referenced as negatively biased. Accordingly, the region 907 and the region 915 may be specified as having a negative bias.

Returning to Figure 8, the method 801 additionally includes an operation 807 for determining a local bias based upon the biasing features identified by the operation 805. In various implementations of the invention, a single biasing feature is identified by the operation 805. Accordingly, various implementations will determine the local bias as corresponding to the bias of the identified biasing feature. For example, if the biasing feature 935 is identified as the only biasing feature near the region 903, it may be determined that the region 903 has a local bias of horizontal. With various implementations of the invention, a portion of a biasing feature is identified as near a particular region. For example, the portion 943 of the basing feature 937 may be identified as near the region 929. Those of skill in the art will appreciate that although a biasing features or a portion of a biasing feature, such as the portion 943, may be located inside a particular region, the biasing feature may still be "classified" as "near" the biasing feature. In various implementations of the invention, the actual bias of features inside a region is given greater weight than nearby features not located inside the region.

Still, with various implementations of the invention, no biasing features will be identified by the operation 805. Accordingly, various implementations of the invention may not assign a local bias to that particular region or may assign a "null" bias to that particular region. Alternatively, with various other implementations of the invention, the local bias will be determined as "any". For example, none of the biasing features 935 - 939 are identified as near the region 919. As a result, various implementations may determine the local bias of the region 919 to be "any" or "null."

With still other implementations of the invention, multiple biasing features will be identified by the operation 805. Alternatively, a single biasing feature having multiple biases will be identified by the operation 805. For example, the biasing features 935, having a horizontal and a negative bias may be identified as near the region 907. Accordingly, in various implementations of the invention a counting function may be employed to determine the local bias as corresponding to the greatest type of biasing features, such as horizontal. In various implementations of the invention, the length of the biasing features is accounted for when determining the local bias. More particularly, the combined length of the various biasing features may be used to determine local layer bias. For example, a regions having 2 horizontal biasing features and one vertical biasing feature may be assigned a vertical bias if the vertical biasing feature has a greater length than the combined horizontal biasing features.

The method 801 additionally includes an operation 809 for generating a layer bias map (not shown,) based upon the local biases determined by the operation 807. As stated above, various implementations of the invention will employ a matrix format for the layer bias map. Accordingly, Table 1 below illustrates a layer bias map corresponding to the partitioned layer 901, which may be generated according to various implementations of the invention. As can be seen in Table 1, there are 4 columns and 4 rows, creating 16 cells corresponding to the 16 regions 903 - 933. Additionally, as can be seen. Each cell indicates a bias for the corresponding region. For example, column 1, row 1, specifies a "horizontal" bias, which corresponds to the bias of region 903.

**Table 1: Layer bias map according to various implementations of the invention.**

| | | | |
|---|---|---|---|
| HORIZONTAL | HORIZONTAL | NEGATIVE | NULL |
| NULL | VERTICAL | NEGATIVE | HORIZONTAL |
| NULL | VERTICAL | POSITIVE | HORIZONTAL |
| HORIZONTAL | HORIZONTAL | POSITIVE | NULL |

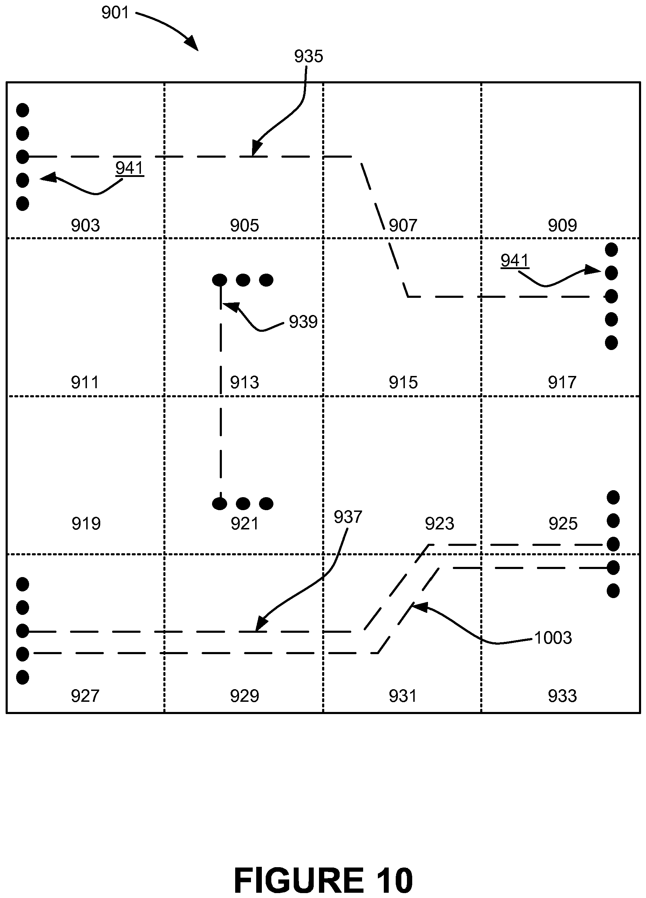

Figure 10 illustrates the partitioned layer 901 of Figure 9, with an additional biasing feature 1003 added to the layout design. Returning now to Figure 5, the layer bias map 511 may be regenerated or updated when features within the layout design are updated. More particularly, a layer bias map corresponding to the partitioned layer 901 may be updated to account for the additional biasing feature 1003 illustrated in Figure 10. Table 2 below illustrates the layer bias map shown in Table 1, updated according to various implementations of the invention to correspond to the partitioned layer 901 illustrated in Figure 10.

**Table 2: Layer bias map according to various implementations of the invention.**

| | | | |
|---|---|---|---|
| HORIZONTAL | HORIZONTAL | NEGATIVE | NULL |
| NULL | VERTICAL | NEGATIVE | HORIZONTAL |
| NULL | VERTICAL | POSITIVE | HORIZONTAL |
| HORIZONTAL | HORIZONTAL | POSITIVE | HORIZONTAL |

### Automated Trace Routing Based Upon A Layer Bias Map

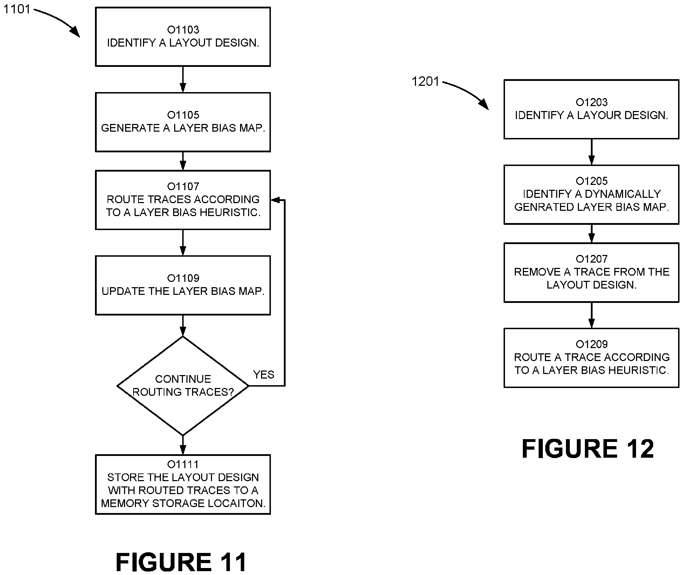

As stated above, automated trace routing tools may route traces according to various heuristics, such as the layer bias heuristic. In various implementations of the invention, a layer bias map, such as the layer bias map illustrated in Table 2, may be employed by an automated trace routing tool. More particularly, an automated trace routing tool may route traces in accordance with a layer bias heuristic and a dynamically updated layer bias map. Figure 11 illustrates a method 1101 that may be implemented according to various embodiments of the present invention. The method 1101 includes an operation 1103 for identifying a portion of a layout design, an operation 1105 for generating a layer bias map corresponding to the portion of the layout design, an operation 1107 for routing traces according to a layer bias heuristic, and an operation 1109 for updating the layer bias map. In various implementations of the invention, the layout design represents a physical layout design for a printed circuit board. With various implementations, the layout design represents a physical layout design for an integrated circuit.

In various implementations of the invention, the operation 1105 for identifying a layer bias map corresponding to the portion of the layout design generates a layer bias map as described above. For example, the operation 1105 may be performed by the method 501 illustrated in Figure 5. With various implementations of the invention, the operation 1107 employs an automated trace routing tool to route traces according to a layer bias heuristic, wherein the layer bias is determined based upon the layer bias map. Still, with various implementations of the invention, the operation 1107 routes the traces based upon a plurality of heuristics, one of which is the layer bias heuristic.

The operation 1109 updates the layer bias map to reflect any changes resulting from the additionally routed trace. As can be seen from Figure 11, the operation 1107 for routing traces and the operation 1109 for updating the layer bias map may be continued. With various implementations of the invention, the process is continued until all netlines within the layout design have been routed as traces. Still, with various implementations of the invention, the process is continued until a predefined number of traces have been routed. Still again, with various implementations of the invention, the process is continued until a predefined number of regions within the layout design have a layer bias associated with them in the layer bias map.

Figure 12 illustrates a method 1201 that may be implemented according to various embodiments of the present invention to facilitate the automated routing of traces in a layout design. The method 1201 includes an operation 1203 for identifying a layout design. In various implementations of the invention, the identified layout design is a portion of a physical layout design for an electronic device, such as a printed circuit board.

The method 1201 further includes an operation 1205 for dynamically generating a layer bias map. In various implementations of the invention, the operation 1205 dynamically generates a layer bias map according to the method 1101 illustrated in Figure 11. With other implementations of the invention, the operation 1205 identifies an already dynamically generated layer bias map that corresponds to the identified layout design. For example, a layer bias map generated according to the method 501 illustrated in Figure 5.

The method 1201 additionally includes an operation 1207 for removing a trace in the identified layout design and an operation 1209 for routing a trace in the identified layout design based upon a layer bias heuristic. In various implementations of the invention, the operation 1207 removes selected traces from the layout design. With various implementations of the invention, the operation 1207 removes all traces from the layout design.

### Apparatus For Dynamically Generating A Layer Bias Map

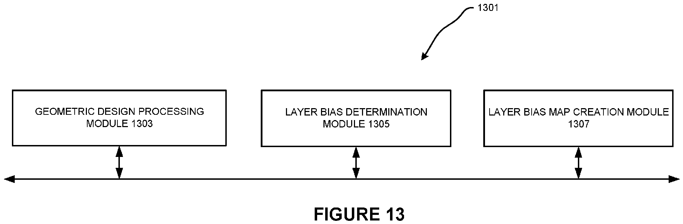

Figure 13 illustrates an apparatus 1301 for dynamically generating a layer bias map. As can be seen in Figure 13, the apparatus 1301 includes a module 1303 for processing a geometric design, such as a layout design for a printed circuit board. The apparatus 1301 further includes a module 1305 for determining a layer bias, and a module 1307 for creating a layer bias map. In various implementations of the invention, the module 1303 - 1307 are program executable on a programmable computer. Accordingly, the modules 1303 - 1307 are capable of accessing, altering, saving, generating, and displaying data representing physical layout designs, for example a layout design for a printed circuit board.

### Conclusion

Although certain devices and methods have been described above in terms of the illustrative embodiments, the person of ordinary skill in the art will recognize that other embodiments, examples, substitutions, modification and alterations are possible.

## Claims

1. A computer-implemented method for modifying an electronic device design layout having a plurality of layers, comprising:
identifying a portion of a design layout, the portion of the design layout representing a physical layout of an electronic device, and the portion of the design layout having one or more original traces;
determining a local trace routing direction bias for a selected region of a layer of the identified portion based in part on the direction of the one or more original traces, the layer comprising a plurality of regions for selection;
adding one or more traces to the selected region of the layer of the identified portion of the device design layout, the positioning of the one or more added traces being based at least in part upon the determined local trace routing direction bias; and
storing the portion of the design layout to a memory storage location.

2. The method of claim 1, further comprising:
removing one or more traces; and
adding one or more traces to the portion of the device design layout,
the positioning of the one or more added traces being based at least in part upon the trace routing direction bias.

3. The method of claim 2, wherein the predetermined operations for:
removing one or more traces, and
adding one or more traces to the portion of the device design layout; being repeated until a condition is satisfied.

4. The method recited in claim 3, wherein the condition is any one or more of the following conditions: i) that vias are minimized; ii) that through hole vias are minimized; iii) that the number of vias used in each trace is minimized; and/or iv) that trace length is minimized.

5. The method recited in claim 3, wherein the traces are placed by a user.

6. The method recited in any of claims 1 to 5, the one or more original traces being netlines or unplanned netlines.

7. The method recited in any of claims 1 to 6, further comprising:
identifying a secondary trace routing direction bias;
removing one or more traces; and
adding one or more traces to the portion of the device design layout,
the positioning of the one or more added traces being based at least in part upon the secondary trace routing direction bias.

8. A computer program product for enabling a computer to alter a portion of a layout design having a plurality of layers comprising:
software instructions for enabling a computer to perform a set of predetermined operations; and
one or more computer readable storage medium bearing the software instructions;
the set of predetermined operations including:
identifying a portion of a design layout, the portion of the design layout representing a physical layout of an electronic device, and the portion of the design layout having one or more original traces;
determining a local trace routing direction bias for a selected region of a layer of the identified portion based in part on the direction of the one or more original traces, the layer comprising a plurality of regions for selection;
adding one or more traces to the selected region of the layer of the identified portion of the device design layout, the positioning of the one or more added traces being based at least in part upon the determined local trace routing direction bias; and
storing the portion of the design layout to a memory storage location.

9. The computer program product recited in claim 8, the set of predetermined operations further comprising:
removing one or more traces; and
adding one or more traces to the portion of the device design layout,
the positioning of the one or more added traces being based at least in part upon the trace routing direction bias

10. The computer program product recited in claim 8, wherein the predetermined operations for:
removing one or more traces, and
adding one or more traces to the portion of the device design layout; being repeated until a condition is satisfied.

11. The computer program product recited in claim 10, wherein the condition is any one or more of the following conditions: i) that vias are minimized; ii) that through hole vias are minimized; iii) that the number of vias used in each trace is minimized; and/or iv) that trace length is minimized.

12. The computer program product recited in any of claims 8 to 11, the one or more original traces being any one or more of: i) user defined traces; ii) netlines; and/or iii) unplanned netlines.

13. The computer program product recited in any of claims 8 to 12, further comprising:
identifying a secondary trace routing direction bias;
removing one or more traces; and
adding one or more traces to the portion of the device design layout,
the positioning of the one or more added traces being based at least in part upon the secondary trace routing direction bias.

14. A computer system adapted to manipulate design data comprising:
a processor; and
a memory including software instructions that cause the computer system to perform operations including:
identifying a portion of a design layout having a plurality of layers, the portion of the design layout representing a physical layout of an electronic device, and the portion of the design layout having one or more original traces;
determining a local trace routing direction bias for a selected region of a layer of the identified portion based in part on the direction of the one or more original traces, the layer comprising a plurality of regions for selection;
adding one or more traces to the selected region of the layer of the identified portion of the device design layout, the positioning of the one or more added traces being based at least in part upon the determined local trace routing direction bias; and
storing the portion of the design layout to a memory storage location.

## Patentansprüche

1. Computerimplementiertes Verfahren zum Modifizieren eines Designlayouts einer elektronischen Vorrichtung, das mehrere Schichten aufweist, wobei das Verfahren aufweist:
Identifizieren eines Abschnitts eines Designlayouts, wobei der Abschnitt des Designlayouts ein physikalisches Layout einer elektronischen Vorrichtung repräsentiert und wobei der Abschnitt des Designlayouts eine oder mehrere Originalleiterbahnen aufweist;
Bestimmen einer lokalen Leiterbahnführungstendenz für einen ausgewählten Bereich einer Schicht des identifizierten Abschnitts auf der Grundlage teilweise der Richtung der einen oder mehreren Originalleiterbahnen, wobei die Schicht mehrere Bereiche zur Auswahl aufweist;
Hinzufügen von einer oder mehreren Leiterbahnen zu dem ausgewählten Bereich der Schicht des identifizierten Abschnitts des Designlayouts der Vorrichtung, wobei die Positionierung der einen oder mehreren hinzugefügten Leiterbahnen auf mindestens teilweise der bestimmten lokalen Leiterbahnführungstendenz basiert; und
Speichern des Abschnitts des Designlayouts an einem Speicherort.

2. Verfahren nach Anspruch 1, das außerdem aufweist:
Entfernen von einer oder mehreren Leiterbahnen; und
Hinzufügen von einer oder mehreren Leiterbahnen zu dem Abschnitt des Designlayouts der Vorrichtung,
wobei die Positionierung der einen oder mehreren hinzugefügten Leiterbahnen auf mindestens teilweise der Leiterbahnführungstendenz basiert.

3. Verfahren nach Anspruch 2, wobei die vorbestimmten Betriebe zum Entfernen von einer oder mehreren Leiterbahnen und
Hinzufügen von einer oder mehreren Leiterbahnen zu dem Abschnitt des Vorrichtungsdesignlayouts
wiederholt werden, bis eine Bedingung erfüllt ist.

4. Verfahren nach Anspruch 3, wobei die Bedingung eine oder mehrere aus den folgenden Bedingungen ist: i) dass Durchgänge minimiert werden; ii) dass Durchgangslöcher minimiert werden; iii) dass die Anzahl von Durchgängen, die in jeder Leiterbahn verwendet werden, minimiert wird; und/oder iv) dass eine Leiterbahnlänge minimiert wird.

5. Verfahren nach Anspruch 3, wobei die Leiterbahnen von einem Nutzer platziert werden.

6. Verfahren nach einem der Ansprüche 1 bis 5, wobei die eine oder mehrere Originalleiterbahnen Netzlinien oder ungeplante Netzlinien sind.

7. Verfahren nach einem der Ansprüche 1 bis 6, das außerdem aufweist:
Identifizieren einer sekundären Leiterbahnführungstendenz;
Entfernen von einer oder mehreren Leiterbahnen; und
Hinzufügen von einer oder mehreren Leiterbahnen zu dem Abschnitt des Designlayouts der Vorrichtung,
wobei die Positionierung der einen oder mehreren Leiterbahnen auf mindestens teilweise der sekundären Leiterbahnführungstendenz basiert.

8. Computerprogrammprodukt zum Ermöglichen, dass ein Computer einen Abschnitt eines Layoutdesigns, das mehrere Schichten aufweist, ändern kann, wobei das Computerprogrammprodukt aufweist:
Softwareanweisungen zum Ermöglichen, dass ein Computer einen Satz vorbestimmter Betriebe durchführt; und
ein oder mehrere computerlesbare Speichermedien, die die Softwareanweisungen halten;
wobei der Satz vorbestimmter Betriebe enthält:
Identifizieren eines Abschnitts eines Designlayouts, wobei der Abschnitt des Designlayouts ein physikalisches Layout einer elektronischen Vorrichtung repräsentiert und wobei der Abschnitt des Designlayouts eine oder mehrere Originalleiterbahnen aufweist;
Bestimmen einer lokalen Leiterbahnführungstendenz für einen ausgewählten Bereich einer Schicht des identifizierten Abschnitts auf der Grundlage teilweise der Richtung der einen oder mehreren Originalleiterbahnen, wobei die Schicht mehrere Bereiche zur Auswahl aufweist;
Hinzufügen von einer oder mehreren Leiterbahnen zu dem ausgewählten Bereich der Schicht des identifizierten Abschnitts des Designlayouts der Vorrichtung, wobei die Positionierung der einen oder mehreren hinzugefügten Leiterbahnen auf mindestens teilweise der bestimmten lokalen Leiterbahnführungstendenz basiert; und
Speichern des Abschnitts des Designlayouts an einem Speicherort.

9. Computerprogrammprodukt nach Anspruch 8, wobei der Satz vorbestimmter Betriebe außerdem aufweist:
Entfernen von einer oder mehreren Leiterbahnen, und
Hinzufügen von einer oder mehreren Leiterbahnen zu dem Abschnitt des Designlayouts der Vorrichtung,
wobei die Positionierung der einen oder mehreren hinzugefügten Leiterbahnen mindestens teilweise auf der Leiterbahnführungstendenz basiert.

10. Computerprogrammprodukt nach Anspruch 8, wobei die vorbestimmten Betriebe zum
Entfernen von einer oder mehreren Leiterbahnen, und
Hinzufügen von einer oder mehreren Leiterbahnen zu dem Abschnitt des Vorrichtungsdesignlayouts
wiederholt werden, bis eine Bedingung erfüllt ist.

11. Computerprogrammprodukt nach Anspruch 10, wobei die Bedingung eine oder mehrere aus den folgenden Bedingungen ist: i) dass Durchgänge minimiert werden; ii) dass Durchgangslöcher minimiert werden; iii) dass die Anzahl von Durchgängen, die in jeder Leiterbahn verwendet werden, minimiert wird; und/oder iv) dass eine Leiterbahnlänge minimiert wird.

12. Computerprogrammprodukt nach einem der Ansprüche 8 bis 11, wobei die eine oder mehreren Originalleiterbahnen eine oder mehrere aus den folgenden sind: i) von einem Nutzer definierte Leiterbahnen; ii) Netzlinien; und/oder iii) ungeplante Netzlinien.

13. Computerprogrammprodukt nach einem der Ansprüche 8 bis 12, das außerdem aufweist:
Identifizieren einer sekundären Leiterbahnführungstendenz;
Entfernen von einer oder mehreren Leiterbahnen; und
Hinzufügen von einer oder mehreren Leiterbahnen zu dem Abschnitt des Vorrichtungsdesignlayouts,
wobei die Positionierung der einen oder mehreren hinzugefügten Leiterbahnen auf mindestens teilweise der sekundären Leiterbahnführungstendenz basiert.

14. Computersystem, das ausgelegt ist, Designdaten zu manipulieren, wobei das Computersystem aufweist:
einen Prozessor; und
einen Speicher, der Softwareanweisungen enthält, die bewirken, dass das Computersystem Betriebe durchführt, die enthalten:
Identifizieren eines Abschnitts eines Designlayouts, das mehrere Schichten aufweist, wobei der Abschnitt des Designlayouts ein physikalisches Layout einer elektronischen Vorrichtung repräsentiert und wobei der Abschnitt des Designlayouts eine oder mehrere Originalleiterbahnen aufweist;
Bestimmen einer lokalen Leiterbahnführungstendenz für einen ausgewählten Bereich einer Schicht des identifizierten Abschnitts auf der Grundlage teilweise der Richtung der einen oder mehreren Originalleiterbahnen, wobei die Schicht mehrere Bereiche zur Auswahl aufweist;
Hinzufügen von einer oder mehreren Leiterbahnen zu dem ausgewählten Bereich der Schicht des identifizierten Abschnitts des Designlayouts der Vorrichtung, wobei die Positionierung der einen oder mehreren hinzugefügten Leiterbahnen auf mindestens teilweise der bestimmten lokalen Leiterbahnführungstendenz basiert; und
Speichern des Abschnitts des Designlayouts an einem Speicherort.

## Revendications

1. Procédé implémenté par ordinateur de modification d'une topologie de conception de dispositif électronique ayant une pluralité de couches, comprenant :
l'identification d'une portion d'une topologie de conception, la portion de la topologie de conception représentant une topologie physique d'un dispositif électronique, et la portion de la topologie de conception ayant une ou plusieurs traces originales ;
la détermination d'un biais de direction de routage de trace local pour une région sélectionnée d'une couche de la portion identifiée en se basant en partie sur la direction des une ou plusieurs traces originales, la couche comprenant une pluralité de régions pour sélection ;
l'addition d'une ou plusieurs traces à la région sélectionnée de la couche de la portion identifiée de la topologie de conception de dispositif, le positionnement des une ou plusieurs traces additionnées étant basé au moins en partie sur le biais de direction de routage de trace local déterminé ; et
le stockage de la portion de la topologie de conception dans un emplacement de stockage en mémoire.

2. Procédé selon la revendication 1, comprenant en outre :
le retrait d'une ou plusieurs traces ; et
l'addition d'une ou plusieurs traces à la portion de la topologie de conception de dispositif,
le positionnement des une ou plusieurs traces additionnées étant basé au moins en partie sur le biais de direction de routage de trace.

3. Procédé selon la revendication 2, dans lequel les opérations prédéterminées pour :
retirer une ou plusieurs traces, et
additionner une ou plusieurs traces à la portion de la topologie de conception de dispositif ;
étant répétées jusqu'à ce qu'une condition soit satisfaite.

4. Procédé selon la revendication 3, dans lequel la condition est une ou plusieurs quelconques des conditions suivantes : i) que des trous d'interconnexion soient minimisés ; ii) que des trous d'interconnexion traversants soient minimisés ; iii) que le nombre de trous d'interconnexion utilisés dans chaque trace soit minimisé ; et/ou iv) que la longueur de trace soit minimisée.

5. Procédé selon la revendication 3, dans lequel les traces sont placées par un utilisateur.

6. Procédé selon l'une quelconque des revendications 1 à 5, les une ou plusieurs traces originales étant des lignes réseau ou des lignes réseau non planifiées.

7. Procédé selon l'une quelconque des revendications 1 à 6, comprenant en outre :
l'identification d'un biais de direction de routage de trace secondaire ;
le retrait d'une ou plusieurs traces ; et
l'addition d'une ou plusieurs traces à la portion de la topologie de conception de dispositif,
le positionnement des une ou plusieurs traces additionnées étant basé au moins en partie sur le biais de direction de routage de trace secondaire.

8. Produit-programme d'ordinateur permettant à un ordinateur de modifier une portion d'une conception de topologie ayant une pluralité de couches comprenant :
des instructions logicielles permettant à un ordinateur de réaliser un jeu d'opérations prédéterminées ; et
un ou plusieurs supports de stockage lisibles par ordinateur portant les instructions logicielles ;
le jeu d'opérations prédéterminées incluant :
l'identification d'une portion d'une topologie de conception, la portion de la topologie de conception représentant une topologie physique d'un dispositif électronique, et la portion de la topologie de conception ayant une ou plusieurs traces originales ;
la détermination d'un biais de direction de routage de trace local pour une région sélectionnée d'une couche de la portion identifiée en se basant en partie sur la direction des une ou plusieurs traces originales, la couche comprenant une pluralité de régions pour sélection ;
l'addition d'une ou plusieurs traces à la région sélectionnée de la couche de la portion identifiée de la topologie de conception de dispositif, le positionnement des une ou plusieurs traces additionnées étant basé au moins en partie sur le biais de direction de routage de trace local déterminé ; et
le stockage de la portion de la topologie de conception dans un emplacement de stockage en mémoire.

9. Produit-programme d'ordinateur selon la revendication 8, le jeu d'opérations prédéterminées comprenant en outre :
le retrait d'une ou plusieurs traces ; et
l'addition d'une ou plusieurs traces à la portion de la topologie de conception de dispositif,
le positionnement des une ou plusieurs traces additionnées étant basé au moins en partie sur le biais de direction de routage de trace.

10. Produit-programme d'ordinateur selon la revendication 8, dans lequel les opérations prédéterminées pour :
retirer une ou plusieurs traces, et
additionner une ou plusieurs traces à la portion de la topologie de conception de dispositif ;
étant répétées jusqu'à ce qu'une condition soit satisfaite.

11. Produit-programme d'ordinateur selon la revendication 10, dans lequel la condition est une ou plusieurs quelconques des conditions suivantes : i) que des trous d'interconnexion soient minimisés ; ii) que des trous d'interconnexion traversants soient minimisés ; iii) que le nombre de trous d'interconnexion utilisés dans chaque trace soit minimisé ; et/ou iv) que la longueur de trace soit minimisée.

12. Produit-programme d'ordinateur selon l'une quelconque des revendications 8 à 11, les une ou plusieurs traces originales étant une ou plusieurs quelconques parmi :
i) des traces définies par utilisateur ; ii) des lignes réseau ; et/ou iii) des lignes réseau non planifiées.

13. Produit-programme d'ordinateur selon l'une quelconque des revendications 8 à 12, comprenant en outre :
l'identification d'un biais de direction de routage de trace secondaire ;
le retrait d'une ou plusieurs traces ; et
l'addition d'une ou plusieurs traces à la portion de la topologie de conception de dispositif,
le positionnement des une ou plusieurs traces additionnées étant basé au moins en partie sur le biais de direction de routage de trace secondaire.

14. Système d'ordinateur adapté pour manipuler des données de conception comprenant :
un processeur ; et
une mémoire incluant des instructions logicielles qui amènent le système d'ordinateur à réaliser des opérations incluant :
l'identification d'une portion d'une topologie de conception ayant une pluralité de couches, la portion de la topologie de conception représentant une topologie physique d'un dispositif électronique, et la portion de la topologie de conception ayant une ou plusieurs traces originales ;
la détermination d'un biais de direction de routage de trace local pour une région sélectionnée d'une couche de la portion identifiée en se basant en partie sur la direction des une ou plusieurs traces originales, la couche comprenant une pluralité de régions pour sélection ;
l'addition d'une ou plusieurs traces à la région sélectionnée de la couche de la portion identifiée de la topologie de conception de dispositif, le positionnement des une ou plusieurs traces additionnées étant basé au moins en partie sur le biais de direction de routage de trace local déterminé ; et
le stockage de la portion de la topologie de conception dans un emplacement de stockage en mémoire.
